# EUROPEAN PATENT APPLICATION

(11) **EP 4 583 158 A2**
(43) Date of publication of application: **09.07.2025**
(21) Application number: 25177611.8
(22) Date of filing: 02.08.2021
(51) Int. Cl.: H01L 23/427

(54) **IMMERSION COOLING DEVICE, HEAT PIPE, AND COLD PLATE**

(30) Priority: 07.08.2020 JP 2020134947
(62) Divisional of application: 21854296.7
(71) Applicant: Daikin Industries, Ltd., Osaka-shi, Osaka 530-0001 (JP)
(72) Inventor: Nakaue, Tsubasa, Osaka-shi, Osaka 530-0001 (JP)
(74) Representative: Hoffmann Eitle

(57) **Abstract**

The present disclosure provides an immersion cooling device comprising electrical and electronic equipment, a fluorine-based insulation refrigerant, and a refrigerant tank for storing the fluorine-based insulation refrigerant, wherein the electrical and electronic equipment is at least partially immersed in the fluorine-based insulation refrigerant, and the fluorine-based insulation refrigerant has a boiling point of 50 to 60°C.

## Description

### Technical Field

The present disclosure relates to an immersion cooling device.

### Background Art

A cooling system for electronic equipment using a fluorine-based cooling liquid has been known (e.g., Patent Literature 1).

### Citation List

### Patent Literature

PTL 1: JP2016-46431A

### Summary of Invention

### Technical Problem

An object of the present disclosure is to provide an immersion cooling device for use in the immersion cooling of electrical and electronic equipment.

### Solution to Problem

Item 1. An immersion cooling device comprising
   electrical and electronic equipment,
   a fluorine-based insulation refrigerant, and
   a refrigerant tank for storing the fluorine-based insulation refrigerant,
   wherein the electrical and electronic equipment is at least partially immersed in the fluorine-based insulation refrigerant, and
   wherein the fluorine-based insulation refrigerant has a boiling point of 50 to 60°C.
Item 2. The immersion cooling device according to Item 1, wherein the fluorine-based insulation refrigerant has an electrical resistivity of 1 × 10⁷ to 1 × 10¹⁵ Ω·cm.
Item 3. The immersion cooling device according to Item 1 or 2, wherein
   the fluorine-based insulation refrigerant comprises 1,1,1,3,3,3-hexafluoroisopropyl methyl ether (HFE-356 mmz) and/or 1,1,2,3,3,3-hexafluoropropyl methyl ether (HFE-356 mec).
Item 4. The immersion cooling device according to Item 3, wherein the refrigerant tank further stores methanol.
Item 5. A heat pipe comprising
   a hermetic container,
   an evaporation part connected to the hermetic container,
   a condensation part connected to the hermetic container, and
   a fluorine-based insulation refrigerant enclosed in the hermetic container,
   wherein the fluorine-based insulation refrigerant comprises 1,1,2,3,3,3-hexafluoropropyl methyl ether (HFE-356 mec).
Item 6. The heat pipe according to Item 5, wherein the fluorine-based insulation refrigerant further comprises 1,1,1,3,3,3-hexafluoroisopropyl methyl ether (HFE-356 mmz).
Item 7. The heat pipe according to Item 5 or 6, wherein methanol is further enclosed in the hermetic container.
Item 8. A cold plate comprising
   a heat-receiving part,
   a heat-releasing part, and
   a circulation route through which a fluorine-based insulation refrigerant circulates,
   wherein the fluorine-based insulation refrigerant has a boiling point of 50 to 60°C.

### Advantageous Effects of Invention

According to the immersion cooling device of the present disclosure, electrical and electronic equipment can be efficiently cooled.

### Brief Description of Drawings

Fig. 1 schematically illustrates the schematic structure of the immersion cooling device in the present disclosure.
Fig. 2 schematically illustrates the schematic structure of the heat pipe in the present disclosure.

### Description of Embodiments

### Definition of Terms

The numerical range expressed by using the term "to" in this specification indicates a range that includes numerical values shown before and after "to" as the minimum and maximum values.

In this specification, "A and/or B" means either A or B, or both A and B.

In this specification, the term "refrigerant" includes at least compounds that are specified in ISO 817 (International Organization for Standardization), and that are given a refrigerant number (ASHRAE number) representing the type of refrigerant with "R" at the beginning; and further includes refrigerants that have properties equivalent to those of such refrigerants, even though a refrigerant number is not yet given. Refrigerants are broadly divided into fluorocarbon compounds and non-fluorocarbon compounds in terms of the structure of the compounds. Fluorocarbon compounds include hydrofluoroethers (HFE). Non-fluorocarbon compounds include propane (R290), propylene (R1270), butane (R600), isobutane (R600a), carbon dioxide (R744), ammonia (R717), and the like.

In this specification, examples of the electrical and electronic equipment include servers, such as computers, server computers, and blade servers; disk arrays/storage systems; storage area networks; storage connected to a network; storage communication systems; workstations; routers; telecommunications infrastructure/switches; wired, optical, and wireless communications equipment; cell processing equipment; printers; power supplies; displays; optical equipment; measurement systems, including hand-held systems; military electronics; etc.

In this specification, the semiconductor element is a heating element mounted on electrical and electronic equipment, such as a CPU, GPU, and SSD. Examples of the semiconductor element include a single atom of silicon and germanium, and a compound semiconductor of gallium arsenide (GaAs), gallium phosphide (GaP), indium phosphide (InP), gallium nitride (GaN), silicon carbide (SiC), etc.

In this specification, when the electrical and electronic equipment is a server computer, one or multiple logic boards are placed in the internal space. The logic board comprises a number of heat-generating electronic components containing at least one processor, such as a CPU and GPU. Additionally, other heat-generating components of a computer, such as a chipset, memory, graphics chips, network chips, RAM, power supplies, daughter cards, and storage drives, such as solid-state drives and mechanical hard disks, can be immersed in a cooling solution of a fluorine-based insulation refrigerant.

In this specification, "immersion cooling" means a technique in which the electrical and electronic equipment, which is a material to be cooled, is immersed in a tank for storing a refrigerant, and heat generated by the immersion is taken by the refrigerant to cool the electrical and electronic equipment, which is a material to be cooled. Typically, a refrigerant with a relatively low temperature is supplied to a tank in which a refrigerant is stored, and a refrigerant having a relatively high temperature that has been warmed by taking heat of the electrical and electronic equipment is discharged from the tank, and the electrical and electronic equipment is continuously cooled. "Immersion cooling systems" using such immersion cooling are, for example, used for cooling the electrical and electronic equipment composing a computer system with a relatively high heat generation density or implementation density, such as a supercomputer or a high-performance computer. The refrigerant used for immersion cooling systems requires insulation, safety, cooling efficiency, and heat transport efficiency, and further a low GWP.

In this specification, the GWP is calculated as specified in the IPCC Fifth Assessment Report (AR5).

### Immersion Cooling Device

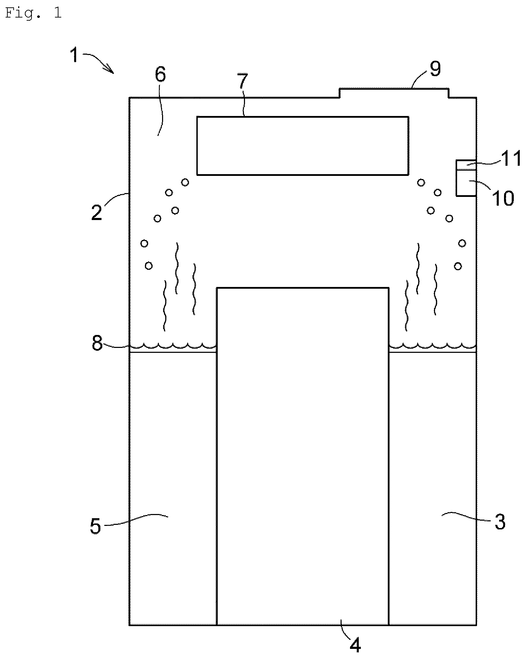

As shown in Fig. 1, the immersion cooling device of the present disclosure comprises electrical and electronic equipment, a fluorine-based insulation refrigerant, and a refrigerant tank for storing the fluorine-based insulation refrigerant, wherein the electrical and electronic equipment is at least partially immersed in the fluorine-based insulation refrigerant. In the immersion cooling device of the present disclosure, the boiling point of the fluorine-based insulation refrigerant is 50 to 60°C.

The immersion cooling device of the present disclosure is used for immersion cooling of the electrical and electronic equipment. According to the immersion cooling device of the present disclosure, the electrical and electronic equipment (in particular, a semiconductor element mounted on the electrical and electronic equipment) can be efficiently cooled.

In this specification, the electrical and electronic equipment being at least partially immersed in the fluorine-based insulation refrigerant means that the electrical and electronic equipment is fully or partially immersed in the fluorine-based insulation refrigerant.

The refrigerant tank preferably comprises an upper portion and a lower portion. The refrigerant tank preferably comprises a gas storing part in the upper portion. The refrigerant tank preferably comprises a refrigerant liquid storing part for storing the fluorine-based insulation refrigerant in the lower portion.

It is preferable that the gas storing part comprises a condenser. The condenser can condense vapor of the fluorine-based insulation refrigerant and return it back to liquid. A liquefied fluorine-based insulation refrigerant flows down to the refrigerant liquid storing part.

The immersion cooling device of the present disclosure preferably comprises a refrigerant tank for storing a fluorine-based insulation refrigerant in which the electrical and electronic equipment is at least partially immersed, and a condenser, which is provided in the gas storing part of the refrigerant tank, and condenses vapor of the fluorine-based insulation refrigerant and returns it back to liquid, wherein the fluorine-based insulation refrigerant preferably has a boiling point of 50 to 60°C.

In the present disclosure, heat is taken from the electrical and electronic equipment by vaporization of the fluorine-based insulation refrigerant to cool the electrical and electronic equipment. The evaporated fluorine-based insulation refrigerant reaches a condenser, which is mounted on the gas storing part in the refrigerant tank, wherein the heat is released to the outside of the immersion cooling device and liquefied. The liquefied fluorine-based insulation refrigerant flows down the wall of the refrigerant tank to the refrigerant liquid storing part. By repeating this process, heat is transferred between the refrigerant liquid storing part and the condenser. The refrigerant liquid storing part of the refrigerant tank is on the cooling side and the condenser is on the heat-releasing side.

It is preferable that the immersion cooling device of the present disclosure further comprises a liquid level sensor for detecting the liquid level of the fluorine-based insulation refrigerant stored in the refrigerant tank.

In the immersion cooling device of the present disclosure, the refrigerant tank preferably comprises a refrigerant tank body part and a detachable refrigerant tank lid part.

In the immersion cooling device of the present disclosure, a filtration part capable of capturing floating materials (e.g., debris) contained in the condensed fluorine-based insulation refrigerant is preferably placed in the gas storing part of the refrigerant tank.

In the present disclosure, natural convection circulation heat transfer and/or forced circulation heat transfer can be used in combination with a cooling method by vaporization. Natural convection circulation heat transfer is a method in which a refrigerant is circulated by natural convection to transfer heat without using power such as a pump. In contrast, forced circulation heat transfer is a method in which a refrigerant is forcibly circulated using power such as a pump and compressor. Specific examples of forced circulation heat transfer include a method in which in secondary cooling for sending heat taken from the object to be cooled to another cooling device via a secondary cooling loop, a pump is used to circulate a liquid refrigerant that circulates the secondary cooling loop.

In the immersion cooling device of the present disclosure, a drying agent for trapping moisture is preferably placed in the filtration part.

The fluorine-based insulation refrigerant used in the immersion cooling device of the present disclosure has high electrical insulation and heat conductivity, which allows the electrical and electronic equipment to be efficiently cooled. Furthermore, the fluorine-based insulation refrigerant used in the immersion cooling device of the present disclosure has low GWP and excellent performance, such as sufficient stability, low toxicity, low flammability, and high cooling efficiency.

In the immersion cooling device of the present disclosure, the electrical resistivity of the fluorine-based insulation refrigerant is preferably 1 × 10⁷ and 1 × 10¹⁵ Ω·cm.

In the immersion cooling device of the present disclosure, the latent heat of evaporation of the fluorine-based insulation refrigerant is preferably 100 to 200 J/g. A latent heat of evaporation of 100 J/g or more reduces the amount of a refrigerant passing between the tubes of the heat exchanger, resulting in less resistance (reduction in pressure loss). Low pressure loss is preferable because the boiling point does not change, and the performance as a refrigerant is not lowered.

In the immersion cooling device of the present disclosure, the dielectric strength of the fluorine-based insulation refrigerant is preferably 15 to 30 kV.

In the immersion cooling device of the present disclosure, the heat conductivity of the fluorine-based insulation refrigerant is preferably 0.05 to 0.12 W/mK. A heat conductivity within this range is preferable because of excellent heat release properties to outside air.

In the immersion cooling device of the present disclosure, the fluorine-based insulation refrigerant has a GWP of 400 or less.

The refrigerant tank stores the electrical and electronic equipment as an object to be cooled. The electrical and electronic equipment can be stored into the refrigerant tank body from the refrigerant tank lid part. The electrical and electronic equipment is stored in the refrigerant tank body part while it is immersed in the fluorine-based insulation refrigerant liquid.

The immersion cooling device of the present disclosure is preferably used for the immersion cooling of a semiconductor element mounted on electrical and electronic equipment. The immersion cooling device of the present disclosure is more suitably used in the immersion cooling of electrical and electronic equipment in a data center. The immersion cooling device of the present disclosure is particularly suitably used for immersion cooling in a data center of a semiconductor element mounted on electrical and electronic equipment.

In the immersion cooling device of the present disclosure, the fluorine-based insulation refrigerant preferably comprises 1,1,1,3,3,3-hexafluoroisopropyl methyl ether (HFE-356 mmz) and/or 1,1,2,3,3,3-hexafluoropropyl methyl ether (HFE-356 mec). The HFE-356 mmz is represented by the chemical formula (CF₃)₂CHOCH₃, and is a refrigerant with a CAS registration number of 13171-18-1. The HFE-356 mmz has a boiling point of 51°C and a global warming potential (GWP) of 14. HFE-356 mec is represented by the chemical formula CF₃CHFCF₂OCH₃ and is a refrigerant with a CAS registration number of 382-34-3. The HFE-356 mec has a boiling point of 54°C and a GWP of 387.

In the immersion cooling device of the present disclosure, the refrigerant tank preferably stores a fluorine-based insulation refrigerant and methanol. In this case, the fluorine-based insulation refrigerant preferably comprises HFE-356 mmz and/or HFE-356 mec.

The fluorine-based insulation refrigerant of the present disclosure can be suitably used for cooling electrical and electronic equipment in a cold plate and a heat pipe.

### Composition For Use In Immersion Cooling

The composition of the present disclosure is a composition for use in immersion cooling containing refrigerant 1. Hereinafter, the composition for use in immersion cooling containing refrigerant 1 is also referred to simply as "composition 1".

Refrigerant 1 comprises 1,1,1,3,3,3-hexafluoroisopropyl methyl ether (HFE-356 mmz) and/or 1,1,2,3,3,3-hexafluoropropyl methyl ether (HFE-356 mec) as essential components. In other words, composition 1 of the present disclosure comprises HFE-356 mmz and/or HFE-356 mec as refrigerant 1.

It is preferable that refrigerant 1 further comprises methanol. Composition 1 of the present disclosure is more preferably an immersion cooling composition containing HFE-356 mmz and methanol as refrigerant 1. Composition 1 of the present disclosure is more preferably an immersion cooling composition containing HFE-356 mec and methanol as refrigerant 1.

If refrigerant 1 comprises HFE-356 mmz and methanol, the total amount of the HFE-356 mmz and methanol in all of refrigerant 1 is preferably 99.5 mass% or more, more preferably 99.7 mass% or more, even more preferably 99.8 mass% or more, and still more preferably 99.9 mass% or more.

It is particularly preferable that refrigerant 1 comprises HFE-356 mmz and methanol alone (however, an unavoidable impurity can be contained as a refrigerant).

If refrigerant 1 comprises HFE-356 mmz and methanol, HFE-356 mmz is contained in an amount of 94.00 to 99.9999 mass%, and methanol is contained in an amount of 6.00 to 0.0001 mass% based on 100 mass% of the total amount of HFE-356 mmz and methanol.

If refrigerant 1 comprises HFE-356 mmz and methanol, HFE-356 mmz is preferably contained in an amount of 95.00 to 99.00 mass%, and methanol is contained in an amount of 5.00 to 1.00 mass% based on 100 mass% of the total amount of HFE-356 mmz and methanol.

If refrigerant 1 comprises HFE-356 mmz and methanol, HFE-356 mmz is particularly preferably contained in an amount of 96.00 to 98.50 mass%, and methanol is contained in an amount of 4.00 to 1.50 mass% based on 100 mass% of the total amount of HFE-356 mmz and methanol.

It is preferable that refrigerant 1 comprises HFE-356 mmz and methanol alone, and HFE-356 mmz is preferably contained in an amount of 94.00 to 99.9999 mass%, and methanol is contained in an amount of 6.00 to 0.0001 mass% based on 100 mass% of the total amount of HFE-356 mmz and methanol (however, an unavoidable impurity can be contained as a refrigerant).

In the present disclosure, the composition comprising HFE-356 mmz and methanol has high insulation and high heat capacity (specific heat), and is chemically inactive. The composition is suitably used as a refrigerant for immersion cooling for electronic hardware devices such as servers.

If refrigerant 1 comprises HFE-356 mec and methanol, the total amount of HFE-356 mec and methanol in all of refrigerant 1 is preferably 99.5 mass% or more, more preferably 99.7 mass% or more, even more preferably 99.8 mass% or more, and still more preferably 99.9 mass% or more.

It is particularly preferable that refrigerant 1 comprises HFE-356 mec and methanol alone (however, an unavoidable impurity can be contained as a refrigerant).

In the present disclosure, the composition containing HFE-356 mec and methanol has high insulation and high heat capacity (specific heat), and is chemically inert; accordingly, it is suitably used as an immersion cooling refrigerant for electronic hardware devices such as servers.

The composition 1 of the present disclosure is preferably used for immersion cooling of a semiconductor element mounted on electrical and electronic equipment. Composition 1 of the present disclosure is more preferably used in the immersion cooling of electrical and electronic equipment in a data center. Composition 1 of the present disclosure is particularly preferably used for immersion cooling in a data center of a semiconductor element mounted on electrical and electronic equipment.

The immersion cooling method of the present disclosure is a method including the step of immersing electrical and electronic equipment in an immersion tank in which refrigerant 1 is stored, and cooling the electrical and electronic equipment.

In the present disclosure, it is preferable to use refrigerant 1 for immersion cooling of electrical and electronic equipment. In the present disclosure, it is more preferable to use refrigerant 1 for immersion cooling of electrical and electronic equipment immersed in a liquid immersion bath in which refrigerant 1 is stored.

### Heat Pipe

The heat pipe of the present disclosure comprises a hermetic container, an evaporation part connected to the hermetic container, a condensation part connected to the hermetic container, and a fluorine-based insulation refrigerant enclosed in the hermetic container. In the heat pipe of the present disclosure, the fluorine-based insulation refrigerant comprises 1,1,2,3,3,3-hexafluoropropyl methyl ether (HFE-356 mec).

In the heat pipe of the present disclosure, the evaporation part is connected to one end of the hermetic container, and the condensation part is connected to the other end of the hermetic container.

In the heat pipe of the present disclosure, the fluorine-based insulation refrigerant preferably comprises HFE-356 mec and 1,1,1,3,3,3-hexafluoroisopropyl methyl ether (HFE-356 mmz).

In the heat pipe of the present disclosure, the inside of the hermetic container is preferably filled with HFE-356 mec and methanol, and more preferably filled with HFE-356 mec, HFE-356 mmz, and methanol.

The heat pipe of the present disclosure preferably comprises a wick (core) for allowing the fluorine-based insulation refrigerant to flow by capillary action inside the hermetic container. In this case, the fluorine-based insulation refrigerant as a working fluid absorbs heat at the evaporation part to become vapor, which moves through the center of the hermetic container to the other end, where the refrigerant releases heat to become liquid. The liquid returns to the evaporation part via a wick capillary. By repeating these steps, heat can be transferred from one end to the other end without the need for power.

### Cold Plate

The cold plate of the present disclosure comprises a heat-receiving part that receives heat from a heating element, a heat-releasing part that releases heat, and a circulation route that circulates the fluorine-based insulation refrigerant by means of a pump. In the cold plate of the present disclosure, the boiling point of the fluorine-based insulation refrigerant is 50 to 60°C.

In the cold plate of the present disclosure, the fluorine-based insulation refrigerant preferably comprises 1,1,1,3,3,3-hexafluoroisopropyl methyl ether (HFE-356 mmz) and/or 1,1,2,3,3,3-hexafluoropropyl methyl ether (HFE-356 mec).

A server is generally cooled by fan-air cooling of a heat sink placed on a CPU; however, in the cold plate of the present disclosure, a metal plate that is designed so that a fluorine-based insulation refrigerant is circulated inside the metal plate is placed in a heat-receiving part that receives heat from the heating element, such as a CPU. The fluorine-based insulation refrigerant flows into the inside of the cold plate through a tube on one side of the metal plate to exchange heat (absorb heat) with the CPU etc. Thereafter, circulation is made such that the fluorine-based insulation refrigerant then flows out of the other pipe of the cold plate, exchanges heat (releases heat) with a coolant distribution unit (CDU), and again flows back to the cold plate for cooling.

Although embodiments are described above, it can be understood that various modifications in form and details may be made without departing from the spirit and scope of the claims.

### Examples

The present disclosure is described in more detail below with reference to Examples. However, the present disclosure is not limited to the Examples.

### Example 1

As the electrical and electronic equipment, a computer stick from which a cooling fan had been removed beforehand (product name: Compute Stick CSTK-32W, produced by I-O Data Device Co., Ltd.) was placed in a refrigerant tank of an immersion cooling device. Subsequently, as the fluorine-based insulation refrigerant, 1,1,1,3,3,3-hexafluoroisopropyl methyl ether (HFE-356 mmz) was stored in a refrigerant tank (length: 10 cm, width: 10 cm, and height: 15 cm). Thereafter, the computer stick was then completely immersed in HFE-356 mmz, and a maximum load was applied to the central processing unit (CPU), which was the heat-generating part of the computer stick, using OCTT, which was a CPU load tool.

By vaporization of HFE-356 mmz, heat generated in the CPU of the computer stick was consumed, and the computer stick was cooled. The evaporated HFE-356 mmz was transferred to a condenser, which was mounted on the gas storing part of the refrigerant tank, and heat was released to the outside of the immersion cooling device via the condenser. The evaporated HFE-356 mmz was then condensed and liquefied, and the liquefied HFE-356 mmz flowed down the wall of the refrigerant tank, and was circulated in the storage part of the refrigerant tank.

This condition was maintained for two weeks, and the appearance, purity, and fluorine ion concentration, and the CPU temperature of the computer stick were confirmed after one week and two weeks. The results are shown in Table 1 below.

**Table 1**

| | After one week | After two weeks |
|---|---|---|
| Appearance | Colorless and transparent | Colorless and transparent |
| Purity | No change | No change |
| Fluorine ion concentration | Less than 1 ppm | Less than 1 ppm |
| CPU temperature | 51°C | 51°C |

In Table 1, appearance being colorless and transparent means that the appearance of HFE-356 mmz observed by naked eye is colorless and transparent. Purity means the purity of HFE-356 mmz measured by gas chromatography analysis. No change means that the purity of HFE-356 mmz does not change before and after the test; i.e., degradation etc. do not occur after one or two weeks of maintaining the condition. Fluorine ion concentration means the fluorine ion concentration of HFE-356 mmz, which was measured by ion chromatography analysis. A fluorine ion concentration of less than 1 ppm means that fluorine ions are not free, i.e., not decomposed. The CPU temperature means the CPU temperature of a computer stick fully immersed in the HFE-356 mmz. It is indicated that the temperature does not increase to the boiling temperature (51°C) of the HFE-356 mmz or more; specifically, even two weeks after maintaining the condition, the computer stick is still efficiently cooled.

### Example 2

30 mL of HFE-356 mec was introduced as a working fluid into a hermetic container of a boiling cooler (hereinafter referred to as "heat pipe") formed of a copper pipe having an outer diameter of 17 mm, a wall thickness of 2.0 mm, and a length of 500 mm.

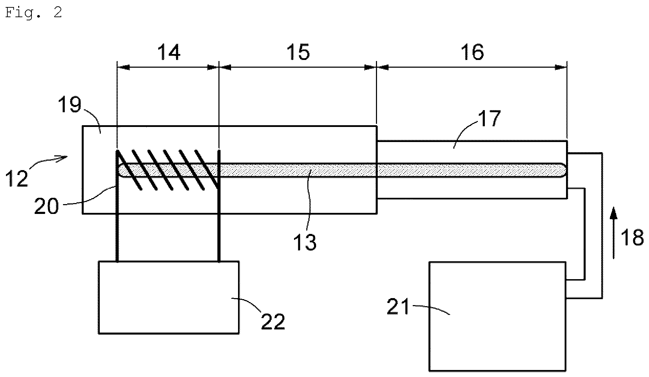

As shown in Fig. 2, using one end of a heat pipe as an evaporation part, a heater was wound around at a specific interval, and a voltage was applied to the heater to adjust the heat amount. A cooling block was attached to the other end of the heat pipe to form a condensation part, and cooling water was supplied and circulated in the cooling block to adjust the released heat amount according to the temperature of cooling water. Furthermore, the part between the evaporation part and the condensation part in the heat pipe was defined as a heat insulation part and insulated with a heat insulation material.

Considering that heat insulation is sufficiently performed, the heat amount of the evaporation part was taken as a heat transfer amount. The input heat amount (W) according to the heater was changed to various amounts, and the relationship between the input heat amount (W) and the working fluid pressure (MPa) and the working fluid heat resistance (°C/W) in the heat pipe was determined. Table 2 shows the results.

The working fluid heat resistance (°C/W) was determined by dividing the difference between the internal temperature (°C) at the center of the evaporation part and the internal temperature (°C) at the center of the condensation part by the input heat amount of the heater.

**Table 2**

| Input heat amount (W) | Internal temperature (°C) at the center of the evaporation part | Internal temperature (°C) at the center of the condensation part | Working fluid heat resistance (°C/W) | Working fluid pressure (MPa) |
|---|---|---|---|---|
| 50 | 37 | 35 | 0.04 | 0.049 |
| 100 | 43 | 40 | 0.03 | 0.06 |
| 150 | 59 | 55 | 0.027 | 0.104 |
| 200 | 64 | 60 | 0.02 | 0.123 |
| 250 | 70 | 65 | 0.02 | 0.146 |
| 300 | 75 | 70 | 0.017 | 0.171 |

From Table 2, it was confirmed that there is no acute change in working fluid heat resistance in the range in which the input heat amount of a heater was 50 W to 300 W. Further, in the range in which the input heat amount was 50 W to 300 W, the working fluid heat resistance was 0.1°C/W or less, and the heat resistance was small. From this, it was confirmed that the use of HFE-356 mec ensured efficient heat transfer.

### Example 3

The dielectric strength of HFE-356 mmz and HFE-356 mec was measured. The measurement was made according to the method described in the measurement method standard JIS C 2101. The dielectric strength of HFE-356 mmz was 20 kV, and the dielectric strength of HFE-356 mec was 26 kV, which indicated that both had very high dielectric strength.

The electrical resistivity of HFE-356 mmz and HFE-356 mec was each measured. The measurement was made according to the method described in the measurement method standard JIS C 2101. The electrical resistivity of HFE-356 mmz was 2.7 x 10⁹ (Ω·cm), and the electrical resistivity of HFE-356 mec was 2.5 x 10⁹ (Ω·cm), which indicated that both had very high electrical resistivity.

The results of Example 3 are shown in Table 3. For comparison with HFE-356 mmz and HFE-356 mec, Table 3 shows the dielectric strength and electrical resistivity of commercially available products of a fluorine-based insulation refrigerant, i.e., Novec 7100 and Novec 7200 produced by 3M Japan KK.

**Table 3**

| | HFE-356 mmz | HFE-356 mec | Novec 7200 | Novec 7100 |
|---|---|---|---|---|
| Dielectric strength (kv) | 20 | 26 | 23 | 28 |
| Electrical resistivity (Ω · cm) | 2.7 x 10⁹ | 2.5 × 10⁹ | 1.0 × 10⁸ | 1.0 × 10⁹ |

### Description of Reference Numerals

1: Immersion cooling device
2: Refrigerant tank
3: Fluorine-based insulation refrigerant
4: Electrical and electronic equipment
5: Refrigerant liquid storing part
6: Gas storing part
7: Condenser
8: Liquid level sensor
9: Refrigerant tank lid part
10: Filtration part
11: Drying agent
12: Heat pipe
13: Hermetic container
14: Evaporation part
15: Insulation part
16: Condensation part
17: Cooling block
18: Cooling water
19: Heat insulation material
20: Heater
21: Thermostatic water tank
22: Power source

List of embodiments

### [Embodiment 1]

An immersion cooling device comprising
electrical and electronic equipment,
a fluorine-based insulation refrigerant, and
a refrigerant tank for storing the fluorine-based insulation refrigerant,
wherein the electrical and electronic equipment is at least partially immersed in the fluorine-based insulation refrigerant, and
wherein the fluorine-based insulation refrigerant has a boiling point of 50 to 60°C.

### [Embodiment 2]

The immersion cooling device according to Embodiment 1, wherein the fluorine-based insulation refrigerant has an electrical resistivity of 1 × 10⁷ to 1 × 10¹⁵ Ω·cm.

### [Embodiment 3]

The immersion cooling device according to Embodiment 1 or 2, wherein the fluorine-based insulation refrigerant comprises 1,1,1,3,3,3-hexafluoroisopropyl methyl ether (HFE-356 mmz) and/or 1,1,2,3,3,3-hexafluoropropyl methyl ether (HFE-356 mec).

### [Embodiment 4]

The immersion cooling device according to Embodiment 3, wherein the refrigerant tank further stores methanol.

### [Embodiment 5]

A heat pipe comprising
a hermetic container,
an evaporation part connected to the hermetic container,
a condensation part connected to the hermetic container, and
a fluorine-based insulation refrigerant enclosed in the hermetic container,
wherein the fluorine-based insulation refrigerant comprises 1,1,2,3,3,3-hexafluoropropyl methyl ether (HFE-356 mec).

### [Embodiment 6]

The heat pipe according to Embodiment 5, wherein the fluorine-based insulation refrigerant further comprises 1,1,1,3,3,3-hexafluoroisopropyl methyl ether (HFE-356 mmz).

### [Embodiment 7]

The heat pipe according to Embodiment 5 or 6, wherein methanol is further enclosed in the hermetic container.

### [Embodiment 8]

A cold plate comprising
a heat-receiving part,
a heat-releasing part, and
a circulation route through which a fluorine-based insulation refrigerant circulates,
wherein the fluorine-based insulation refrigerant has a boiling point of 50 to 60°C.

## Claims

1. A heat pipe comprising
- a hermetic container,
- an evaporation part and a condensation part, each connected to the hermetic container, and
- enclosed in the hermetic container, a fluorine-based insulation refrigerant which consists of 1,1,2,3,3,3-hexafluoropropyl methyl ether (HFE-356 mec).

2. A cold plate comprising a heat-receiving part, a heat-releasing part, and a circulation route through which circulates a fluorine-based insulation refrigerant which (i) has a boiling point of 50-60°C and (ii) comprises 1,1,2,3,3,3-hexafluoropropyl methyl ether (HFE-356 mec).
